# EUROPEAN PATENT SPECIFICATION

(11) **EP 1 661 189 B1**
(45) Date of publication and mention of the grant of the patent: **27.03.2013**
(21) Application number: 04754991.0
(22) Date of filing: 10.06.2004
(51) Int. Cl.: H01L 35/00, F02K 1/82, F02C 6/18, H01L 35/30

(54) **THERMOELECTRIC POWER GENERATOR FOR A GAS TURBINE ENGINE**
THERMOELEKTRISCHER STROMGENERATOR FÜR EINE GASTURBINEN-MASCHINE
GENERATRICE THERMOELECTRIQUE DESTINEE A UNE TURBINE A GAZ

(30) Priority: 30.07.2003 US 631440
(43) Date of publication of application: 31.05.2006
(73) Proprietor: United Technologies Corporation, Hartford, Connecticut 06101 (US)
(72) Inventor: RAVER, Bernard, J., Ellington, CT 06029 (US); JONES, Stephen, R., Columbia, CT 06237 (US); LEVASSEUR, Glenn, N., Colchester, CT 06415 (US)
(74) Representative: Leckey, David Herbert
(86) International application number: PCT/US2004/018585
(87) International publication number: WO 2005/017331

(56) References cited:
- WO-A-01/61768
- JP-A- 2 040 075
- JP-A- 2001 263 088
- US-A- 3 054 840
- US-A- 4 148 192
- US-A- 5 918 458
- US-A- 5 968 456
- US-A- 5 996 336

## Description

### BACKGROUND OF THE INVENTION

### (1) Field of the Invention

The present invention relates to a method of generating electricity from the thermal energy produced in a gas turbine engine.

### (2) Description of Related Art

Engines mounted in aircraft, particularly gas turbine engines, typically generate a great deal of heat. The excessive generation of heat can lead to engine failure. In other instances, such as in stealth aircraft, there is a need to dissipate exhaust heat so as to maintain concealment. In addition, modern avionics and weapon systems place an increased demand for electricity on the aircraft.

What is therefore needed is a method for removing and dissipating the heat generated by a gas turbine engine in an aircraft as well as a method for increasing the generation of electricity. Most preferable would be to devise a method whereby the heat generated in a gas turbine engine can be converted into electricity.

A thermoelectric power generator for an aircraft is disclosed in WO 01/61768. A thermopile having alternating elements of P-type and N-type materials is disclosed in US-A-3054840.

### SUMMARY OF THE INVENTION

It is an object of the present invention to provide a method of generating electricity from the thermal energy produced in a gas turbine engine.

From a first aspect of the invention is provided a method for generating electricity from an engine as claimed in claim 1.

From a second aspect of the invention is provided a method for generating electricity from an engine as claimed in claim 2.

From a third aspect of the invention is provided a turbofan as claimed in claim 10.

### BRIEF DESCRIPTION OF THE DRAWINGS

FIG. 1 is a diagram of the configuration of the P-type and N-type materials of the present invention.
FIG. 2 is a diagram showing the preferred placement of the P-type and N-type materials of the present invention.

### DETAILED DESCRIPTION OF THE PREFERRED EMBODIMENT (S)

It is therefore a central teaching of the present invention to provide a method for applying thermoelectric semiconductor material to the components of a gas turbine engine in order to produce electrical power. In addition, the present invention further enables one to provide electrical current to an operating gas turbine engine so as to quickly remove the heat produced therein.

The fundamental physical principles which form the basis for the present invention are described as follows. The Carnot cycle is associated with the efficiency of a thermoelectric device. The efficiency of the Camot cycle is reduced by a factor which is dependent upon the thermoelectric figure of merit (ZT) of the materials used in fabrication of the thermoelectric device. The coupling between electrical and thermal effects in a material as defined by the dimensionless figure of merit (ZT) is represented as ZT = σ S² T/K where σ is the electrical conductivity, S is the Seebeck coefficient, T is the absolute temperature, and K is the thermal conductivity.

The basic thermoelectric effects at issue in the present invention are the Seebeck and the Peltier effects. The Seebeck effect is the phenomena associated with the conversion of heat energy into electrical power where an induced voltage occurs in the presence of a temperature gradient. As such, the Seebeck effect may be used to generate electricity in the presence of a temperature differential. Conversely, the Peltier effect is a phenomena whereby cooling/heating occurs in the presence of an electrical current through the junction of two dissimilar materials. As a result, the Peltier effect allows one to engage in cooling/thermal management of a material through the addition of electrical current at the junction of dissimilar materials, particularly P-type and N-type materials.

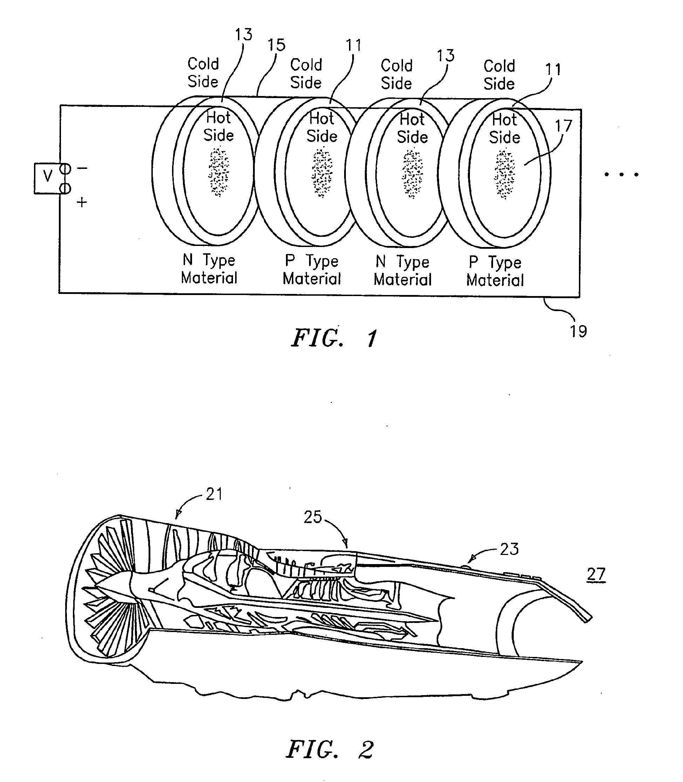

With reference to FIG. 1, there is illustrated the arrangement of P-type materials 11 and N-type materials 13 used to generate electric current from a gas turbine engine. As illustrated, the P-type material 11 and N-type materials 13 are formed into cylindrical rings and are connected in series in alternating fashion by a conductive material such as electric conductor 15. In the present example, both the N-type material 13 and the P-type material 11 are illustrated as generally cylindrical rings of material connected in series surrounding a heated interior 17. The N-type material 13 and P-type material 11 are arranged in alternating fashion. In a preferred embodiment, N-type material 13 and P-type material 11 form continuous bands, or rings, which may be disposed around a heated interior 17 as illustrated.

As can be seen, each N-type material 13 or P-type material 11 is isolated from neighboring materials 13, 11 and is connected only through electric conductor 15. As a result of heated interior 17, each N-type material 13 and P-type material 11 has both a hot side and a cold side. The hot side corresponds to the side closer to the heated interior 17 and, conversely, the cold side corresponds to a side of either N-type material 13 or P-type material 11 located furthest from heated interior 17. The electric conductor 15 connects the cold side of each N-type material 13 to the cold side of a P-type material 11 while another electric conductor 15 connects the hot side of each P-type material 11 to the hot side of an N-type material 13. As a result, electrons gain energy from their surroundings as they move over the barrier at the NP junction. Heat is absorbed on the "hot" side of the N-type and P-type materials and is released on the cold side of the N-type and P-type materials. This gain in electron energy comprises the electrical current which then flows through exemplary circuit 19. Conversely, the process may be reversed, and a current may flow through exemplary circuit 19 so as to move heat away from the interior of N-type materials 13 and P-type materials 11, thus removing a portion of the energy created in heated interior 17.

With reference to FIG. 2, there is illustrated areas of a gas turbine engine 27 most suitably adapted to make use of the present invention. Specifically, fan case section 21, augmentor liner 23, and compressor 25 are ideally constructed to allow for the deposition of N-type material and P-type material in generally encircling bands, in alternating fashion, to generate electricity as described above. In addition to depositing N-type material 13 and P-type material 11 upon components comprising a gas turbine engine, N-type material 13 and P-type material 11 may alternatively be fabricated into the individual components. In such an instance, the N-type materials 13 and P-type materials 11 serve to provide both electricity and structural support for the components of the engine. Examples of N-type material 13 and P-type material 11 include, but are not limited to Si₁₋ₓGeₓ alloys, Skutterudites, and Co-based oxides.

As a result of either depositing upon or fabricating into the components of an engine N-type materials 13 and P-type materials 11, the heat energy of the engine may be used to generate electrical energy without the incorporation of moving parts. As a result, the present invention provides an environmental green methodology for generating electricity from engine heat which involves no compressed gases or chemicals. A turbofan engine, augmented to make use of the present invention, creates a substantial amount of thermal energy differentials. Specifically, such thermal differentials exist in areas between the inside and the outside of the augmentor liner and in the area around the outside of a combustor as noted above. The generation of thermal electric power as described above is well suited to operate in the hostile environments found in and around a gas turbine engine.

It is apparent that there has been provided in accordance with the present invention a method of generating electricity from the thermal energy produced in a gas turbine engine which fully satisfies the objects, means, and advantages set forth previously herein. While the present invention has been described in the context of specific embodiments thereof, other alternatives, modifications, and variations will become apparent to those skilled in the art having read the foregoing description. Accordingly, it is intended to embrace those alternatives, modifications, and variations as fall within the broad scope of the appended claims.

## Claims

1. A method for generating electricity from a turbofan engine comprising the steps of:
depositing a plurality of annular alternating portions of an N-type material (13) and a P-type material (11) on a turbofan engine component;
providing an electrically conductive material (15) between each of two adjoining portions of said N-type material (13) and said P-type material (11) to form a circuit;
operating said engine to generate heat at said component; and
generating electricity from said generated heat using said alternating portions (13,11) of said N-type material and P-type material.

2. A method for generating electricity from a turbofan engine comprising the steps of:
fabricating a plurality of annular portions of an N-type material (13) and a P-type material (11) and arranging said portions on a turbofan engine component to provide alternating portions of an N-type material (13) and a P-type material; and
providing an electrically conductive material to connect each of said plurality of alternating portions of an N-type material (13) and a P-type material (11) in series;
operating said engine to generate heat at said component; and
generating electricity from said generated heat using said alternating portions of said N-type material (13) and P-type material (11).

3. The method of claim 1 comprising the additional step of passing an electrical current through said plurality of alternating portions of said N-type material (13) and said P-type material (11) to draw said generated heat from said engine.

4. The method of any preceding claim wherein said engine component is selected from the group consisting of a fan case section, a combustor, and an augmentor liner.

5. The method of any preceding claim wherein said depositing or arranging step comprises bonding said plurality of alternating portions of said N-type material (13) and said P-type material (11) to a surface of said turbofan engine component.

6. The method of any preceding claim wherein said N-type and said P-type materials (13,11) are selected from the group consisting of Si₁₋ₓGeₓ alloys, skutterudites, and Co-based oxides.

7. The method of any preceding claim comprising the additional step of absorbing said generated heat from a heated interior of said turbofan engine by said N-type material (13) and said P-type material (11).

8. The method of claim 7 comprising the additional step of releasing said absorbed heat of said N-type material (13) and said P-type material (11) through said electrically conductive material (15)

9. The method of any preceding claim comprising the additional step of generating an electric current by absorbing generated heat from a heated interior of said engine by said N-type material (13) and said P-type material (11) and releasing said absorbed heat of said N-type material (13) and said P-type material (11) through said electrically conductive material.

10. A turbofan engine comprising:
at least one turbofan engine component comprising a plurality of alternating portions of an N-type material (13) and a P-type material (11) surrounding a heated interior of said turbofan engine component and connected in series on said engine component via an electrically conductive material (15) to form a circuit, said alternating portions of N-type and P-type materials (13,11) being annular in shape.

11. The engine of claim 10 wherein said engine component is selected from the group consisting of a fan case section, a combustor, and an augmentor liner.

12. The engine of claim 10 or 11 wherein said plurality of alternating portions of an N-type material (13) and a P-type material (11) are formed as deposits upon said engine component.

13. The turbofan engine of claim 12 wherein the deposits form encircling bands along an augmentor liner.

14. The turbofan engine of any of claims 10 to 13 wherein said N-type material (13) and P-type material (11) each possess a hot side and a cold side.

15. The turbofan engine of claim 14 wherein said hot side is closest to said heated interior of said at least one turbofan engine component.

16. The turbofan engine of claim 14 or 15 wherein said cold side is furthest from said heated interior.

17. The turbofan engine of any of claims 10 to 16 wherein said plurality of alternating portions of said N-type material (13) and said P-type material (11) are cylindrical rings surrounding said heated interior.

## Patentansprüche

1. Verfahren zum Erzeugen von Elektrizität von einem Turbogebläsemotor, umfassend die folgenden Schritte:
Abscheiden mehrerer ringförmiger sich abwechselnder Abschnitte von N-Material (13) und P-Material (11) auf ein Turbogebläsemotorbauteil;
Bereitstellen eines elektrisch leitfähigen Materials (15) zwischen jeder der zwei benachbarten Abschnitte des N-Materials (13) und P-Materials (11) zum Bilden einer Schaltung;
Betreiben des Motors zum Erzeugen von Wärme an dem Bauteil; und Erzeugen von Elektrizität aus der erzeugten Wärme unter Verwendung sich abwechselnder Abschnitte (13, 11) des N-Materials und P-Materials.

2. Verfahren zum Erzeugen von Elektrizität von einem Turbogebläsemotor, umfassend die folgenden Schritte:
Herstellen mehrerer ringförmiger Abschnitte eines N-Materials (13) und eines P-Materials (11) und Anordnen der Abschnitte auf einem Turbogebläsemotorbauteil zum Bereitstellen sich abwechselnder Abschnitte eines N-Materials (13) und eines P-Materials; und
Bereitstellen eines elektrisch leitfähigen Materials zum seriellen verbinden jedes der mehreren sich abwechselnden Abschnitte von N-Material (13) und P-Material (11);
Betreiben des Motors zum Erzeugen von Wärme an dem Bauteil; und Erzeugen von Elektrizität aus der erzeugten Wärme unter Verwendung der sich abwechselnden Abschnitte von N-Material (13) und P-Material (11).

3. Verfahren nach Anspruch 1, umfassend den zusätzlichen Schritt des Durchleitens eines elektrischen Stroms durch die mehreren sich abwechselnden Abschnitte von N-Material (13) und P-Material (11) zum Ziehen der erzeugten Wärme aus dem Motor.

4. verfahren nach einem der vorherigen Ansprüche, wobei das Motorbauteil ausgewählt ist aus der Gruppe, bestehend aus einem Gebläsegehäuseabschnitt, Verbrenner und einer Augmentorauskleidung.

5. Verfahren nach einem der vorherigen Ansprüche, wobei der Abscheidungs- oder Anordnungsschritt das Binden der mehreren sich abwechselnden Abschnitte von N-Material (13) und P-Material (11) an eine Oberfläche des Turbogebläsemotorbauteils umfasst.

6. Verfahren nach einem der vorherigen Ansprüche, wobei das N- und das P-Material (13, 11) ausgewählt ist aus der Gruppe, bestehend aus Si₁₋ₓGeₓ-Legierungen, Skutteruditen und Co-basierten Oxiden.

7. Verfahren nach einem der vorherigen Ansprüche, umfassend den zusätzlichen Schritt des Absorbierens der erzeugten Wärme aus einem erwärmten Innenraum des Turbogebläsemotors durch das N-Material (13) und das P-Material (11).

8. Verfahren nach Anspruch 7, umfassend den zusätzlichen Schritt des Freisetzens der absorbierten Wärme des N-Materials (13) und P-Materials (11) durch das elektrisch leitfähige Material (15).

9. verfahren nach einem der vorherigen Ansprüche, umfassend den zusätzlichen Schritt des Erzeugens eines elektrischen Stroms durch Absorbieren der erzeugten Wärme aus einem erwärmten Innenraum des Motors durch das N-Material (13) und das P-Material (11) und Freisetzen der absorbierten Wärme des N-Materials (13) und P-Materials (11) durch das elektrisch leitfähige Material.

10. Turbogebläsemotor, umfassend:
mindestens ein Turbogebläsemotorbauteil, umfassend mehrere sich abwechselnde Abschnitte eines N-Materials (13) und P-Materials (11), die einen erwärmten Innenraum des Turbogebläsemotorbauteils umgeben und über elektrisch leitfähiges Material (15) in Serie auf dem Motorbauteil geschaltet sind, um eine Schaltung zu bilden, wobei die sich abwechselnden Abschnitte von N-Material (13) und P-Material (11) ringförmig sind.

11. Motor nach Anspruch 10, wobei das Motorbauteil ausgewählt ist aus der Gruppe, bestehend aus einem Gebläsegehäuseabschnitt, einem Verbrenner und einer Augmentorauskleidung.

12. Motor nach Anspruch 10 oder 11, wobei die mehreren sich abwechselnden Abschnitte von N-Material (13) und P-Material (11) als Abscheidungen auf dem Motorbauteil ausgebildet sind.

13. Turbogebläsemotor nach Anspruch 12, wobei die Abscheidungen umgebende Bänder entlang der Augmentorauskleidung formen.

14. Turbogebläsemotor nach einem der Ansprüche 10 bis 13, wobei das N-Material (13) und P-Material (11) jeweils eine heiße Seite und eine kalte Seite besitzen.

15. Turbogebläsemotor nach Anspruch 14, wobei die heiße Seite am nächsten zu dem erwärmten Innenraum des mindestens einen Turbogebläsemotorbauteils liegt.

16. Turbogebläsemotor nach Anspruch 14 oder 15, wobei die kalte Seite am weitesten von dem erwärmten Innenraum entfernt ist.

17. Turbogebläsemotor nach einem der Ansprüche 10 bis 16, wobei die mehreren sich abwechselnden Abschnitte von N-Material (13) und P-Material (11) zylinderförmige Ringe sind, die den erwärmten Innenraum umgeben.

## Revendications

1. Procédé pour générer de l'électricité à partir d'un moteur à double flux, comprenant les étapes suivantes:
déposer une pluralité de parties alternées annulaires d'un matériau de type N (13) et d'un matériau de type P (11) sur un composant de moteur à double flux;
prévoir un matériau électriquement conducteur (15) entre chacune de deux parties contiguës dudit matériau de type N (13) et dudit matériau de type P (11) afin de former un circuit;
actionner ledit moteur afin de générer de la chaleur audit composant; et
générer de l'électricité à partir de ladite chaleur générée en utilisant lesdites parties alternées (13, 11) dudit matériau de type N et dudit matériau de type P.

2. Procédé pour générer de l'électricité à partir d'un moteur à double flux, comprenant les étapes suivantes:
fabriquer une pluralité de parties annulaires d'un matériau de type N (13) et d'un matériau de type P (11), et disposer lesdites parties sur un composant de moteur à double flux afin d'obtenir des parties alternées d'un matériau de type N (13) et d'un matériau de type P; et
prévoir un matériau électriquement conducteur afin de connecter chacune de ladite pluralité de parties alternées d'un matériau de type N (13) et d'un matériau de type P (11) en série;
actionner ledit moteur afin de générer de la chaleur audit composant; et
générer de l'électricité à partir de ladite chaleur générée en utilisant lesdites parties alternées dudit matériau de type N (13) et dudit matériau de type P (11).

3. Procédé selon la revendication 1, comprenant l'étape supplémentaire consistant à faire passer un courant électrique à travers ladite pluralité de parties alternées dudit matériau de type N (13) et dudit matériau de type P (11) afin de pomper ladite chaleur générée à partir dudit moteur.

4. Procédé selon l'une quelconque des revendications précédentes, dans lequel ledit composant de moteur est sélectionné dans le groupe comprenant une section de carter de ventilateur, une chambre de combustion et une chemise d'augmentateur.

5. Procédé selon l'une quelconque des revendications précédentes, dans lequel ladite étape de dépôt ou d'agencement comprend la liaison de ladite pluralité de parties alternées dudit matériau de type N (13) et dudit matériau de type P (11) à une surface dudit composant de moteur à double flux.

6. Procédé selon l'une quelconque des revendications précédentes, dans lequel lesdits matériaux de type N et de type P (13, 11) sont sélectionnés dans le groupe comprenant des alliages de Si₁₋ₓGeₓ, des skutterudites et des oxydes à base de Co.

7. Procédé selon l'une quelconque des revendications précédentes, comprenant l'étape supplémentaire consistant à absorber ladite chaleur générée à partir d'un espace intérieur chauffé dudit moteur à double flux par ledit matériau de type N (13) et ledit matériau de type P (11).

8. Procédé selon la revendication 7, comprenant l'étape supplémentaire de libération de ladite chaleur absorbée dudit matériau de type N (13) et dudit matériau de type P (11) à travers ledit matériau électriquement conducteur (15).

9. Procédé selon l'une quelconque des revendications précédentes, comprenant l'étape supplémentaire consistant à générer un courant électrique en absorbant de la chaleur générée à partir d'un espace intérieur chauffé dudit moteur par ledit matériau de type N (13) et ledit matériau de type P (11), et libérer ladite chaleur absorbée dudit matériau de type N (13) et dudit matériau de type P (11) à travers ledit matériau électriquement conducteur.

10. Moteur à double flux, comprenant au moins un composant de moteur à double flux comprenant une pluralité de parties alternées d'un matériau de type N (13) et d'un matériau de type P (11) qui entourent un espace intérieur chauffé dudit composant de moteur à double flux et sont connectés en série audit composant de moteur par l'intermédiaire d'un matériau électriquement conducteur (15) afin de former un circuit, lesdites parties alternées de matériaux de type N et de type P (13, 11) étant de forme annulaire.

11. Moteur à double flux selon la revendication 10, dans lequel ledit composant de moteur est sélectionné dans le groupe comprenant une section de carter de ventilateur, une chambre de combustion et une chemise d'augmentateur.

12. Moteur à double flux selon la revendication 10 ou 11, dans lequel ladite pluralité de parties alternées de matériau de type N (13) et de matériau de type P (11) est formée par des dépôts sur ledit composant de moteur.

13. Moteur à double flux selon la revendication 12, dans lequel les dépôts forment des bandes d'encerclement le long d'une chemise d'augmentateur.

14. Moteur à double flux selon l'une quelconque des revendications 10 à 13, dans lequel ledit matériau de type N (13) et ledit matériau de type P (11) possèdent chacun un côté chaud et un côté froid.

15. Moteur à double flux selon la revendication 14, dans lequel ledit côté chaud est le plus proche dudit espace intérieur chauffé dudit au moins un composant de moteur à double flux.

16. Moteur à double flux selon la revendication 14 ou 15, dans lequel ledit côté froid est le plus éloigné dudit espace intérieur chauffé.

17. Moteur à double flux selon l'une quelconque des revendications 10 à 16, dans lequel ladite pluralité de parties alternées dudit matériau de type N (13) et dudit matériau de type P (11) est constituée d'anneaux cylindriques qui entourent ledit espace intérieur chauffé.
